(19) Europäisches Patentamt / European Patent Office / Office européen des brevets

(11) **EP 4 388 323 B1**

(12) **EUROPÄISCHE PATENTSCHRIFT**

(45) Veröffentlichungstag und Bekanntmachung des Hinweises auf die Patenterteilung:
**01.04.2026 Patentblatt 2026/14**

(21) Anmeldenummer: **22768305.9**

(22) Anmeldetag: **18.08.2022**

(51) Internationale Patentklassifikation (IPC):
**G01P 3/487** *(2006.01)* **B62J 45/412** *(2020.01)*
**B62J 45/423** *(2020.01)* **G01R 33/025** *(2006.01)*

(52) Gemeinsame Patentklassifikation (CPC):
**G01P 3/487; B62J 45/412; B62J 45/423;**
G01R 33/025

(86) Internationale Anmeldenummer:
**PCT/EP2022/073057**

(87) Internationale Veröffentlichungsnummer:
**WO 2023/021130 (23.02.2023 Gazette 2023/08)**

(54) **VERFAHREN ZUR ERMITTLUNG EINER GESCHWINDIGKEIT EINES EINSPURIGEN FAHRZEUGS**

METHOD FOR DETERMINING A SPEED OF A SINGLE-TRACK VEHICLE

PROCÉDÉ DE DÉTERMINATION D'UNE VITESSE D'UN VÉHICULE À VOIE UNIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.08.2021 DE 102021209114**
**17.08.2022 DE 102022208526**

(43) Veröffentlichungstag der Anmeldung:
**26.06.2024 Patentblatt 2024/26**

(73) Patentinhaber: **Robert Bosch GmbH**
**70442 Stuttgart (DE)**

(72) Erfinder:
• **ZEGOWITZ, Michael**
**72070 Tuebingen (DE)**
• **HAU, Julian**
**72768 Reutlingen (DE)**
• **SCHICKLE, Sven**
**72070 Tuebingen (DE)**
• **STEGMAIER, Juergen**
**72827 Wannweil (DE)**

(56) Entgegenhaltungen:
EP-A2- 3 435 094     DE-A1- 19 939 979
DE-T5- 112012 001 676   JP-A- 2014 160 009
US-A1- 2008 315 865    US-A1- 2019 353 677

**Beschreibung**

Stand der Technik

Die Erfindung betrifft ein Verfahren zur Ermittlung einer Geschwindigkeit eines einspurigen Fahrzeugs, insbesondere eines Pedelecs oder dergleichen.
Die Erfindung betrifft weiter ein System zur Ermittlung einer Geschwindigkeit eines einspurigen Fahrzeugs, insbesondere eines Pedelecs oder dergleichen.
Die Erfindung betrifft darüber hinaus eine Geschwindigkeitsmessvorrichtung für ein einspuriges Fahrzeug.
Die Erfindung betrifft weiter ein einspuriges Fahrzeug mit einem System.
Obwohl die vorliegende Erfindung allgemein auf beliebige einspurige Fahrzeuge anwendbar ist, wird die vorliegende Erfindung in Bezug auf Fahrräder in Form von Pedelecs beschrieben.
Pedelecs ermöglichen durch eine Antriebseinheit mit Motor eine Fahrunterstützung für einen Fahrer. Die jeweilige Antriebseinheit umfasst dabei nicht nur den jeweiligen Antriebsmotor, sondern auch Sensorik, um die Fahrgeschwindigkeit des eBikes zu ermitteln. Hierbei ist es bekannt geworden, an einem Rad des Fahrrads einen Magneten anzuordnen, und dessen Magnetfeld mittels eines Magnetfeldsensors zu messen. Der Magnetfeldsensor ist dabei ortsfest am Rahmen, insbesondere in der Antriebseinheit, angeordnet. Bei jedem Umlauf kann so anhand des zeitlichen Abstands zwischen zwei gemessenen Vorbeiläufen des Magnets mittels Messwerten des Sensors und des Reifenumfangs die Geschwindigkeit des Fahrrads ermittelt werden. Problematisch ist, dass Bauteile der Antriebseinheit, wie beispielsweise Getriebezahnräder, Schrauben, Bolzen oder dergleichen aus weichmagnetischem Material hergestellt sein können. Darüber hinaus kann die Einbausituation der Antriebseinheit an verschiedenen Rädern unterschiedlich sein. Beides kann so das Messergebnis des Magnetfeldsensors beeinflussen.
Als Stand der Technik sind bereit die Druckschriften EP 3 435 094 A2, US 2019/353677 A1, US 2008/315865 A1, DE 11 2012 001676 T5, DE 199 39 979 A1 bekannt.

Offenbarung der Erfindung

In einer Ausführungsform stellt die vorliegende Erfindung ein Verfahren zur Ermittlung einer Geschwindigkeit eines einspurigen Fahrzeugs, insbesondere eines Pedelecs oder dergleichen, bereit umfassend die Schritte

- Ermitteln eines zeitlichen Verlaufs eines Magnetfelds von einem an einem Rad des Fahrzeugs angeordneten Magneten in zumindest zwei, insbesondere drei, Raumrichtungen basierend auf Messwerten eines stationär angeordneten Sensors in zumindest zwei, insbesondere drei, Sensorraumrichtungen, wobei die erste der zumindest zwei Raumrichtungen der Fahrtrichtung des Fahrzeugs entspricht und die zweite der zumindest zwei Raumrichtungen der Hochachse des Fahrzeugs entspricht,
- Erkennen einer Flanke im zeitlichen Verlauf des Magnetfelds in einer der beiden Raumrichtungen, vorzugsweise in der ersten Raumrichtung mittels

  ◦ Ermitteln von Hoch- und Tiefpunkten im zeitlichen Verlauf des Magnetfelds,
  ◦ Ermitteln einer fallenden oder steigenden Flanke anhand der zeitlichen Abfolge eines Hoch- und Tiefpunkts,
  ◦ Vergleichen der Amplitude der ermittelten Flanke mit einem Schwellwert, wobei die ermittelte Flanke als erkannt gilt, wenn die Amplitude der ermittelten Flanke größer ist als ein erster niedrigerer Schwellwert und/oder größer ist als ein zweiter größerer adaptiver Schwellwert,

- Ermitteln der Geschwindigkeit des Fahrzeugs anhand von zumindest zwei, insbesondere aufeinanderfolgender, erkannter Flanken.

In einer Ausführungsform stellt die vorliegende Erfindung ein System zur Ermittlung einer Geschwindigkeit eines einspurigen Fahrzeugs, insbesondere eines Pedelecs oder dergleichen, bereit, umfassend einen stationär am Fahrzeug angeordneten Sensor,

eine Ermittlungseinrichtung ausgebildet zum Ermitteln eines zeitliches Verlaufs eines Magnetfelds von einem an einem Rad des Fahrzeugs angeordneten Magneten in zumindest zwei, insbesondere drei, Raumrichtungen basierend auf Messwerten des stationär angeordneten Sensors in zumindest zwei, insbesondere drei, Sensorraumrichtungen, wobei die erste der zumindest zwei Raumrichtungen der Fahrtrichtung des Fahrzeugs entspricht und die zweite der zumindest zwei Raumrichtungen der Hochachse des Fahrzeugs entspricht, eine Flankenerkennungseinrichtung, ausgebildet zum Erkennen einer Flanke im zeitlichen Verlauf des Magnetfelds in einer der beiden Raumrichtungen, vorzugsweise in der ersten Raumrichtung mittels,

- Ermitteln von Hoch- und Tiefpunkten im zeitlichen Verlauf des Magnetfelds,
- Ermitteln einer fallenden oder steigenden Flanke anhand der zeitlichen Abfolge eines Hoch- und Tiefpunkts,
- Vergleichen der Amplitude der ermittelten Flanke mit einem Schwellwert, wobei die ermittelte Flanke als erkannt gilt, wenn die Amplitude der ermittelten Flanke größer ist als ein erster niedrigerer Schwellwert und/oder größer ist als ein zweiter größerer adaptiver Schwellwert und

eine Geschwindigkeitsermittlungseinrichtung ausgebildet zum Ermitteln der Geschwindigkeit des Fahrzeugs anhand von zumindest zwei, insbesondere aufeinanderfolgender, erkannter Flanken.

In einer Ausführungsform stellt die vorliegende Erfindung eine Geschwindigkeitsmessvorrichtung für ein einspuriges Fahrzeug bereit, umfassend ein System wie zuvor beschrieben, und eine Radinformationsbereitstellungseinrichtung, welche ausgebildet ist, Radinformationen des Rades des Fahrzeugs für das System bereitzustellen.

In einer Ausführungsform stellt die vorliegende Erfindung ein einspuriges Fahrzeug mit einem System wie zuvor beschrieben und/oder einer Geschwindigkeitsmessvorrichtung wie zuvor beschrieben bereit.

Einer der damit erzielten Vorteile ist, dass eine robuste und gleichzeitig zuverlässige Ermittlung einer Geschwindigkeit des Fahrzeugs ermöglicht wird. Gleichzeitig wird die Flexibilität erhöht, da größere Toleranzen bei der Anordnung von Sensor und Magnet ermöglicht werden, was zudem die Herstellungskosten und den Zeitaufwand für die Montage reduziert.

Gemäß einer vorteilhaften Weiterbildung werden vor dem Erkennen der Flanke die Messwerte des gemessenen Magnetfelds aufbereitet, insbesondere gefiltert, vorzugsweise mittels eines Bandpassfilters und/oder eines Kerbfilters. Vorteil hiervon ist, dass damit beispielsweise Ausreißer oder dergleichen herausgefiltert werden können, was die Zuverlässigkeit der Erkennung von Flanken verbessert. Mittels eines Kerbfilters können beispielsweise EMV-Störfrequenzen, wie beispielsweise 16,67 Hz, 50 Hz, 60 Hz oder dergleichen gedämpft werden.

Gemäß einer weiteren vorteilhaften Weiterbildung wird ein Sperr- und Durchlassbereich des Bandpassfilters an eine vorgegebene Umdrehungsfrequenz des Rades des Fahrzeugs angepasst. Vorteil hiervon ist eine genauere beziehungsweise geeignetere Filterung in Abhängigkeit beispielsweise der Geschwindigkeit des Fahrrads.

Gemäß einer weiteren vorteilhaften Weiterbildung werden die in mindestens zwei Sensorraumrichtungen ermittelten Messwerte vor dem Erkennen einer Flanke in die Hauptachse des Magnetfelds rotiert. Unter "Raumrichtung" ist synonym eine "Raumachse" zu verstehen. Damit wird die Nutzamplitude für die Erkennung von Flanken erhöht, was insgesamt die Zuverlässigkeit weiter verbessert.

Gemäß einer weiteren vorteilhaften Weiterbildung wird der Winkel der Hauptachse für die Rotation anhand von Messwerten in der zweiten Raumrichtung bestimmt, insbesondere für eine vorgebbare Anzahl von Flanken. Damit kann auf einfache und gleichzeitig zuverlässige Weise der Winkel der Hauptachse bestimmt werden.

Gemäß einer weiteren vorteilhaften Weiterbildung wird der Winkel der Hauptachse gespeichert und für weitere Berechnungen bereitgestellt. Damit kann der ermittelte Wert für weitere Berechnungen und/oder andere Einrichtungen verwendet werden, was Ressourcen spart.

Gemäß einer weiteren vorteilhaften Weiterbildung wird zusätzlich der zeitliche Verlauf des Vektors des Magnetfelds zur Auswertung der steigenden und/oder fallenden Flanken ausgewertet, insbesondere zu deren Plausibilisierung. Vorteil hiervon ist, dass damit die Flankenerkennung noch weiter verbessert wird.

Gemäß einer weiteren vorteilhaften Weiterbildung wird eine ermittelte Flanke mittels eines Plausibilisierungsverfahrens überprüft, wobei eine unplausible ermittelte Flanke verworfen wird. Vorteil hiervon ist, dass damit die Zuverlässigkeit der Geschwindigkeitsmessung noch weiter verbessert wird.

Gemäß einer weiteren vorteilhaften Weiterbildung berechnet das Plausibilisierungsverfahren anhand der ermittelten Flanke eine mögliche Geschwindigkeit und überprüft auf zumindest eine der folgenden Bedingungen:

- Wenn die mögliche Geschwindigkeit oberhalb eines vorgebbaren Schwellwerts liegt, wird die ermittelte Flanke verworfen.
- Wenn der Gradient der ermittelten Flanke unterhalb eines Schwellwerts liegt, wird die ermittelte Flanke verworfen.
- Wenn die Zeitdifferenz zwischen dem Tiefpunkt der ermittelten Flanke und dem Zeitpunkt des Überschreitens eines Schwellwerts in dem Flankenverlauf oberhalb eines vorgebbaren Schwellwerts ist, wird die ermittelte Flanke verworfen.
- Wenn die Fahrzeugbeschleunigungen, berechnet aus einer aktuell ermittelten Flanke und einer früheren Flanke, oberhalb eines vorgebbaren Schwellwerts liegen, wird die aktuell ermittelte Flanke verworfen.

Einer der damit erzielten Vorteile ist, dass damit eine besonders hohe Zuverlässigkeit bei der Plausibilisierung erzielt wird.

Gemäß einer weiteren vorteilhaften Weiterbildung umfasst das Plausibilisierungsverfahren eine Flankenvorhersage, insbesondere anhand von Beschleunigungsdaten des Fahrzeugs, sodass eine erkannte Flanke als unplausibel verworfen wird, wenn anhand der Beschleunigungsdaten keine Flanke vorhergesagt wird. Damit kann die Zuverlässigkeit der Flankenerkennung verbessert werden.

Gemäß einer weiteren vorteilhaften Weiterbildung werden für den Zeitpunkt der Flankenvorhersage und eines Toleranzbereichs zumindest einer der Schwellwerte von erstem und zweitem Schwellwert, insbesondere der zweite Schwellwert, für die Flankenerkennung und -plausibilisierung verringert. Vorteil hiervon ist, dass das Verfahren insbesondere für diesen Zeitbereich sensitiver ist, sodass damit die Zuverlässigkeit der Flankenerkennung und des Plausibilisierungsverfahrens noch weiter verbessert werden kann.

Gemäß einer weiteren vorteilhaften Weiterbildung wird zur Erkennung der Polarisierung des Magneten eine vorgebbare Anzahl von ermittelten Flanken und insbesondere ein Winkelverlauf des Magnetfeldvektors ermittelt, wobei die Polarisierung anhand eines Vergleichs von maximaler Amplitude der steigenden und der fallenden Amplitude ermittelt wird, wobei wenn die maximale fallende Amplitude größer ist als die maximale steigende Amplitude, die Polarisierung des Magneten umgekehrt angenommen wird und die Messwerte des Magnetfelds invertiert werden. Einer der damit erzielten Vorteile ist, dass auf schnelle und einfache Weise, ohne zusätzlichen Aufwand, die Polarisierung des Magneten erkannt werden kann.

Gemäß einer weiteren vorteilhaften Weiterbildung wird die Polarisierung anhand einer vorgebbaren Anzahl von steigenden und/oder fallenden Flanken ausgewertet. Vorteil hiervon ist, dass mit einer ausreichenden Genauigkeit die Polarisierung des Magneten erkannt werden kann.

Weitere wichtige Merkmale und Vorteile der Erfindung ergeben sich aus den Unteransprüchen, aus den Zeichnungen und aus der dazugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungen und Ausführungsformen der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile oder Elemente beziehen.

Dabei zeigt

Figur 1    Schritte eines Verfahrens zur Ermittlung einer Geschwindigkeit eines einspurigen Fahrzeugs gemäß einer Ausführungsform der vorliegenden Erfindung;

Figur 2    Schritte eines Verfahrens zur Ermittlung einer Geschwindigkeit eines einspurigen Fahrzeugs gemäß einer Ausführungsform der vorliegenden Erfindung;

Figur 3    ein Diagramm eines zeitlichen Verlaufs eines gemessenen Magnetfelds gemäß einer Ausführungsform der vorliegenden Erfindung;

Figur 4    eine Darstellung von unterschiedlichen Einbauwinkeln für einen Sensor gemäß einer Ausführungsform der vorliegenden Erfindung; und

Figur 5    eine Geschwindigkeitsmessvorrichtung für ein einspuriges Fahrzeug gemäß einer Ausführungsform der vorliegenden Erfindung.

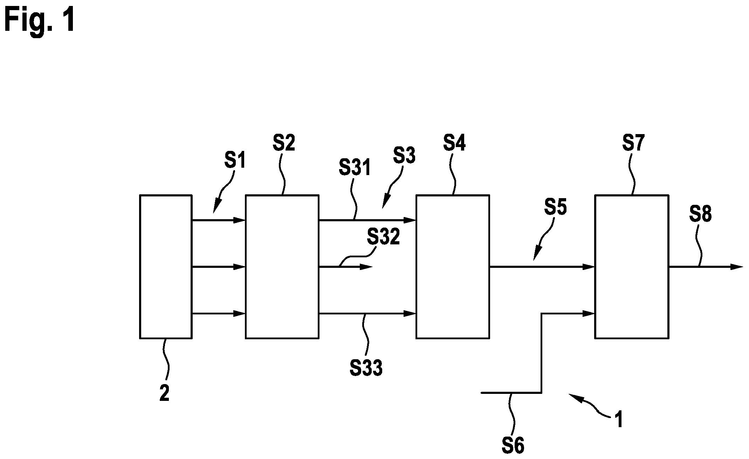

Figur 1 zeigt in schematischer Form Schritte eines Verfahrens zur Ermittlung einer Geschwindigkeit eines einspurigen Fahrzeugs gemäß einer Ausführungsform der vorliegenden Erfindung.

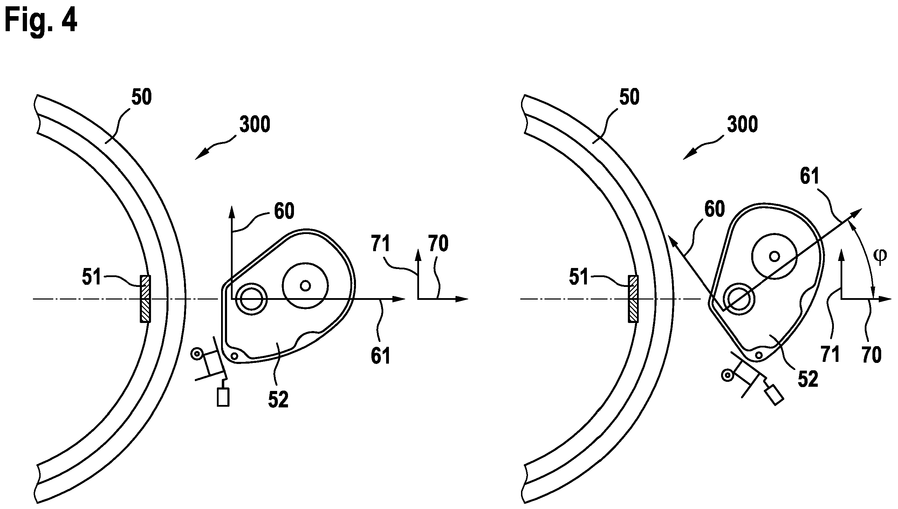

In Figur 1 werden Schritte für eine Geschwindigkeitsmessung 1 anhand eines Felgenmagneten 51 (siehe Figur 4) eines Fahrrads 300 (siehe Figur 4) gezeigt. Hierzu misst ein Magnetfeldsensor 2, der in einer Antriebseinheit 52 (siehe Figur 4) des Fahrrads 300 angeordnet ist, das Magnetfeld in den drei Raumrichtungen x, y und z in einem Schritt S1. Da die vom internen Magnetfeldsensor 2 erfassten Magnetfelder durch umliegende Stahlteile verzerrt werden können, werden diese in einem weiteren Schritt S2 korrigiert. Dadurch kann das Magnetfeld außerhalb der Antriebseinheit 52, also ohne Verzerrungen berechnet werden. Der rotierende Felgenmagnet 2 erzeugt ein Magnetfeld in der Fahrtrichtungsachse 70 und der Hochachse 71 (Bereitstellung der Komponenten des Magnetfelds nach der Korrektur gemäß Schritt S2 im weiteren Schritt S3: Bezugszeichen S31, S33), weshalb diese Daten in einem Felgenmagnet-Erkennungsverfahren S4 ausgewertet werden. Eine Magnetfeldkomponente S32 außerhalb der Fahrzeugebene wird nicht weiter ausgewertet. Hat das Felgenmagnet-Erkennungsverfahren S4 erkannt, dass der Magnet 2 an der Antriebseinheit 52 vorbei rotiert ist und einen Magnetpuls bereitgestellt hat, wird ein Zeitstempel in einem weiteren Schritt S5 erzeugt. Durch die Zeitdifferenz zwischen zwei Pulsen beziehungsweise Vorbeiläufen und dem gemäß dem weiteren Schritt S6 bereitgesellten Radumfang wird anschließend die Geschwindigkeit gemäß dem weiteren Schritt S7 berechnet und ausgegeben gemäß dem weiteren Schritt S8.

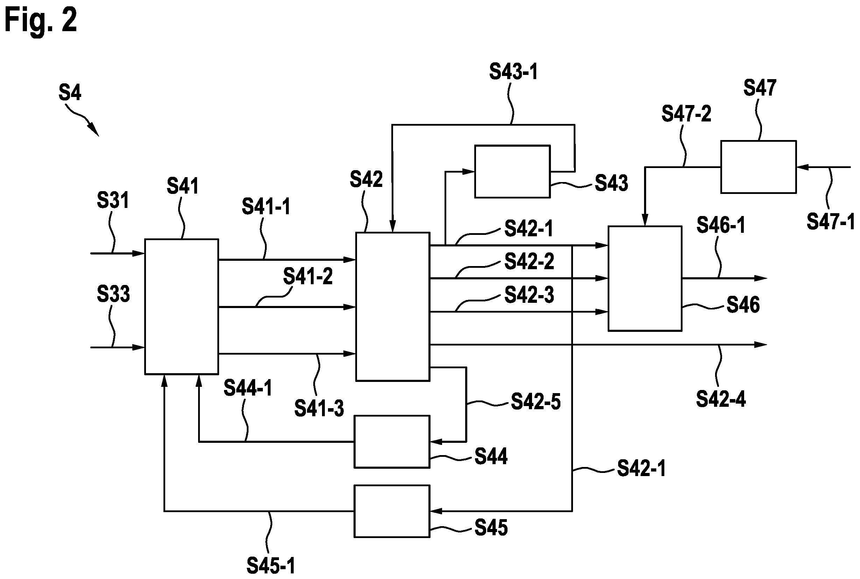

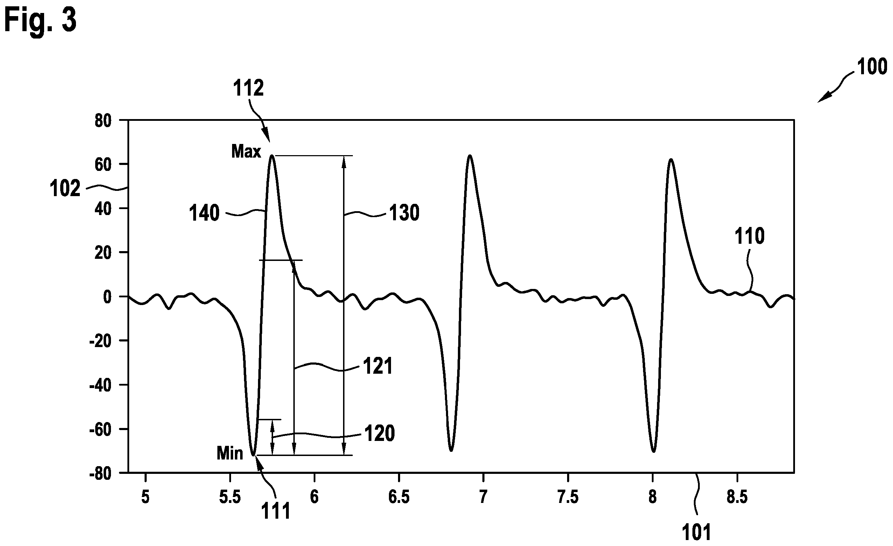

Figur 2 zeigt Schritte eines Verfahrens zur Ermittlung einer Geschwindigkeit eines einspurigen Fahrzeugs gemäß einer Ausführungsform der vorliegenden Erfindung und Figur 3 ein Diagramm eines zeitlichen Verlaufs eines gemessenen Magnetfelds gemäß einer Ausführungsform der vorliegenden Erfindung.

Figur 2 zeigt nun im Detail Schritte eines Felgenmagnet-Erkennungsverfahrens S4 gemäß einer Ausführungsform der vorliegenden Erfindung. Figur 3 zeigt ein Diagramm 100 eines zeitlichen Verlaufs eines gemessenen Magnetfelds gemäß einer Ausführungsform der vorliegenden Erfindung mit Zeitachse 101 und Stärke des Magnetfelds 102.

In Figur 2 werden nun das Magnetfeld in der Fahrtrichtungs- und der Hochachse 70, 71 zunächst einer Signalverarbeitung (Bezugszeichen S41) zugeführt (Bezugszechen S31, S33). Die Magnetfelddaten in Fahrtrichtungs- und Hochachse 70, 71 werden mit einem Bandpassfilter in der Signalverarbeitung S41 gefiltert. Das Filter adaptiert seinen Durchlass- und Sperrbereich, insbesondere je nach momentaner Hinterradfrequenz eines Hinterrads des Fahrrads 300. Außerdem werden bekannte EMV-Störfrequenzen gedämpft.

Die gefilterten Magnetfelddaten werden mit dem Winkel $\varphi$ der Hauptachse rotiert, sodass sich in einer Achse der größte Signalhub befindet. Diese beiden Signale S41-1, S41-2 werden einer Flankenerkennung S42 zugeführt. Die Bestimmung des Winkels $\varphi$ der Hauptachse wird später beschrieben.

Anhand des Magnetfelds in der Fahrtrichtungs- und Hochachse 70, 71 wird der momentane Winkel des Magnetfeldvektors gemäß S41-3 anhand der folgenden Formel berechnet.

$$\propto = atan2\left(Mag\_Hoch, Mag\_Fahrtrichtung\right)$$

wobei Mag_Hoch und Mag_Fahrtrichtung den jeweiligen Signalen beziehungsweise Werten S41-1, S41-2 entspricht, wobei diese gemäß S41-3 ebenfalls der Flankenerkennung S42 bereitgestellt werden.

In dem gefilterten und in die Hauptachse 70 rotierten Magnetfeldsignal, bereitgestellt gemäß S41-1, werden Hochpunkte 112 und Tiefpunkte 111 detektiert. Folgt auf einen Tiefpunkt 111 ein Hochpunkt 112, wird dies als steigende Flanke 140 erkannt. Umgekehrt wird eine fallende Flanke 140 erkannt. Zum Erkennen einer Flanke 140 muss deren Amplitude 130 größer sein als ein erster niedriger Schwellwert 120.

Ist die Differenz zwischen dem erkannten Tiefpunkt 111 und dem aktuellen Wert des Magnetfeldsignals 110 größer als ein gewisser Anteil einer vorgegebenen Amplitude, insbesondere wird die Amplitude eingelernt, repräsentiert durch einen zweiten Schwellwert 121, ist die Amplitude 111, 112 der Flanke 140 plausibel und die detektierte Flanke 140 wird an die Plausibilisierung S46 übermittelt. Zu diesem Zeitpunkt wird insbesondere ein Zeitstempel gemäß S42-4 für die Geschwindigkeitsberechnung gemäß Schritt S7 bestimmt, da dieser Zeitpunkt definierter ist, als der Zeitpunkt des Hochpunktes 112. Da die Geschwindigkeit über die Zeitdifferenz zwischen zwei Pulsen berechnet wird, werden die Zeitstempel (bereitgestellt gemäß S42-4) immer zum gleichen Zeitpunkt einer Flanke 140 generiert.

Wird der erste niedrige Schwellwert 120 überschritten, nicht aber der zweite adaptive Schwellwert 121, wird die Flanke 140 trotzdem an die Plausibilisierung 46 übermittelt. Im Falle einer Pulsvorhersage 47 kann mit den gemäß S47-2 bereitgestellten Daten diese Flanke 140 trotzdem als plausibel gewertet werden. Die Flankenerkennung 42 kann auch fallende Flanken 140 erfassen. Diese werden hier nicht für die Geschwindigkeitsberechnung gemäß S7 verwendet, allerdings sind diese für eine Polarisierungserkennung mittels einer Polarisierungserkennungseinrichtung 45 des Magneten notwendig.

Während des Erkennens einer Flanke 140 wird der Winkel des Magnetfeldvektors berechnet. Bewegt sich das Fahrrad 300 vorwärts und der Felgenmagnet 51 rotiert an der Antriebseinheit 52 vorbei, steigt der Winkel kontinuierlich an. Zusätzlich wird der Winkel des Vektors zu Beginn der Flanke 140, hier beim Tiefpunkt 111, beim Überschreiten des zweiten Schwellwerts 121 und am Ende einer Flanke 140, hier am Hochpunkt 112 bestimmt. Das Winkelsignal, bereitgestellt gemäß S42-3 wird als plausibel bewertet, wenn dieses während der Erkennung einer Flanke 140 die Rotation des Magnetfeldvektors abbildet.

Da der Abstand zwischen Felgenmagnet 51 und Sensor je nach Fahrrad 300 stark variieren kann, beispielsweise abhängig von Rahmengeometrie, Reifen, Felge des Fahrrads 300, variiert auch die Amplitude 130 des Nutzsignals je nach Fahrrad 300. Die Amplitude 130 des Nutzsignals wird individuell eingelernt gemäß Schritt S43 und später zur Plausibilisierung verwendet.

Um möglichst schnell die richtige Amplitude 130 zu kennen, werden die Amplituden 130 der ersten vollständigen steigenden und fallenden Flanken 140, bei welchen das Winkelsignal plausibel ist, gemäß Schritt S43-1 gespeichert. Nach einer gewissen Anzahl an erkannten Flanken wird das Maximum aus den gespeicherten Amplituden 130 berechnet. Ist dies größer als die momentan gespeicherte Amplitude 130, wird dieses für weitere Berechnungen verwendet.

Ist das schnelle Einlernen der Amplitude 130 abgeschlossen, wird die Amplitude 130 anhand jeder vollständigen plausiblen steigenden Flanke 140 mit plausiblem Winkelsignal kontinuierlich nachgelernt.

Beim Ausschalten des Pedelec-Systems wird die eingelernte Amplitude 130 hier in einen nichtflüchtigen Speicher der Antriebseinheit 52 geschrieben. Beim Systemstart wird die zuletzt eingelernte Amplitude 130 aus diesem Speicher geladen und dem System wird nach dem Wiedereinschalten zu Beginn die korrekte eingelernte Amplitude 130 bereitgestellt.

Der Felgenmagnet 51 kann prinzipiell um 180° verdreht montiert werden. Dadurch wird der Signalverlauf invertiert. Dies wird durch die Polarisierungserkennungseinrichtung 45 erkannt und das Signal wird mittels eines Verfahrens, insbesondere eines Software-Programms, wiederum invertiert, sodass das Verfahren weiterhin die steigenden Flanken 140 detektieren kann. Um die Polarisierung des Magneten zu erkennen, werden die Amplituden 130 der ersten steigenden und fallenden Flanken 140 gemäß S43-1 gespeichert, bei denen zusätzlich das Winkelsignal des Magnetfeldvektors plausibel ist, bereitgestellt gemäß S42-3. Wurde eine gewisse Anzahl an Flanken 140 erkannt, wird das Maximum der gespeicherten steigenden Amplituden 130 und das Maximum der gespeicherten fallenden Amplituden 130 berechnet. Ist die maximale fallende Amplitude größer als die maximale steigende Amplitude 130, ist die aktuell verwendete Polarisierung falsch und der Signalverlauf wird durch die Signalverarbeitung 41 mit den entsprechenden Informationen der Polarisierungserkennungseinrichtung 45 invertiert ausgegeben gemäß S45-1.

Diese Überprüfung findet hier mit den ersten Magnetpulsen beim Anfahren des Fahrzeugs statt, da sich prinzipiell bei jedem Anhalten die Polarisierung ändern könnte.

Beim Ausschalten des Pedelec-Systems wird die eingelernte Polarisierung in den nichtflüchtigen Speicher der Antriebseinheit 52 geschrieben. Beim Systemstart wird die zuletzt eingelernte Polarisierung aus dem Speicher geladen und die korrekte Polarisierung bereitgestellt.

Figur 4 zeigt Darstellungen von unterschiedlichen Einbauwinkeln für einen Sensor gemäß einer Ausführungsform der vorliegenden Erfindung.

Die Antriebseinheit 52 und damit der jeweilige Sensor kann in verschiedenen Winkellagen in ein Fahrzeug, beispielsweise ein Pedelec 300, eingebaut werden. Der Sensor misst dann ein Magnetfeld entlang der Sensorraumachsen 60, 61. Die Hauptachse 70, in welcher sich der größte Signalhub befindet, ändert sich jedoch von außen betrachtet nicht. Zu Beginn wird von einem Einbauwinkel von 0° ausgegangen. Auch wenn die Antriebseinheit 52 und damit der Sensor stark verdreht ist, funktioniert das Verfahren gemäß einer Ausführungsform der vorliegenden Erfindung. Die Nutzamplitude ist jedoch geringer und im Falle einer externen Magnetfeldstörung weniger robust.

Deshalb wird mit jeder plausiblen Flanke 140 die Verdrehung $\Delta\varphi$ zur Hauptachse 70 berechnet gemäß S42-5, die Magnetfelddaten entsprechend rotiert gemäß S44 und die Daten entsprechend S44-1 der Signalverarbeitung 41 bereitgestellt.

Hierfür wird während der Flankenerkennung S42 zusätzlich das Magnetfeld in der zweiten Achse, bereitgestellt gemäß Schritt S41-1, ausgewertet. Dadurch erhält man nach wenigen Radumdrehungen die Hauptachse 70 und erzielt auch bei starken Verdrehungen ein Nutzsignal mit großer Amplitude.

Beim Ausschalten des Pedelec-Systems wird der Winkel der eingelernten Hauptachse 70 in den nichtflüchtigen Speicher der Antriebseinheit 52 geschrieben. Beim Systemstart wird der zuletzt eingelernte Winkel aus dem Speicher geladen und es wird nach Wiedereinschalten gleich zu Beginn der korrekte Winkel der Hauptachse 70 bereitgestellt.

Die von der Flankenerkennung S42 detektierten Flanken werden in mehreren Schritten durch die Plausibilisierung S46 plausibilisiert. Hierfür wird von der Flankenerkennung S42 zum einen die Amplitude 130 der Flanke 140 bereitgestellt gemäß S42-1, der Flankengradient bereitgestellt gemäß S42-2 und der plausible Magnetfeldvektor, bereitgestellt gemäß S42-3, der Plausibilisierung S46 bereitgestellt beziehungsweise übermittelt. Wird eine detektierte Flanke 140 als nicht plausibel ermittelt, wird die Flanke 140 und das dazugehörige Zeitstempelsignal, bereitgestellt gemäß S42-4 durch die Flankenerkennung S42, nicht zur Geschwindigkeitsberechnung verwendet. Mit jeder detektierten Flanke 140 wird insbesondere berechnet, welche Geschwindigkeit gemessen würde, wenn diese Flanke 140 plausibel wäre. Dies wird im Folgenden als "mögliche Geschwindigkeit" bezeichnet. Insbesondere werden die Flanken 140 anhand der folgenden Bedingungen beziehungsweise Abfragen plausibilisiert:

1. Ist die mögliche Geschwindigkeit über einem Schwellwert, beispielsweise 100km/h, ist die Flanke 140 unplausibel. Das heißt, dass die Flanken 140 unplausibel schnell aufeinander folgen.

2. Je schneller das Fahrrad 300 fährt, desto größer ist die Geschwindigkeit, mit der sich der Magnet 51 an der Antriebseinheit 52 vorbei bewegt. Deshalb ist bei hohen Geschwindigkeiten auch der Gradient der steigenden Flanke 140 größer und die Zeitdifferenz zwischen dem Tiefpunkt 111 und dem zweiten Schwellwert 121 geringer. Deshalb muss der Gradient der Flanke 140 über einem geschwindigkeitsabhängigen Schwellwert liegen. Außerdem kann insbesondere die Zeitdifferenz zwischen dem Tiefpunkt 111 und dem zweiten Schwellwert 121 kleiner sein als ein zweiter geschwindigkeitsabhängiger Schwellenwert 121. Sind die beiden Bedingungen nicht erfüllt, wird die Flanke 140 als unplausibel gewertet.

3. Mit jeder detektierten Flanke 140 wird die Beschleunigung zwischen der letzten plausiblen Flanke und der aktuell detektierten Flanke 140 berechnet. Ist diese Beschleunigung über einem Schwellwert, ist die Flanke 140 unplausibel. Diese Plausibilisierung wird nur kurzzeitig verwendet, da es ansonsten gegebenenfalls zu einer dauerhaft falschen Geschwindigkeitsmessung führen kann.

Über die Daten des Beschleunigungssensors, die der Pulsvorhersage S47 gemäß S47-1 bereitgestellt werden, wird derjenige Zeitpunkt mittels der Pulsvorhersage S47 vorhergesagt, an dem die nächste plausible Flanke 140 vorliegen müsste. Um diesen Zeitpunkt wird insbesondere ein Fenster gelegt, in dem das Verfahren sensitiver ist. Wird die Amplitude 130 einer Flanke 140 beispielsweise durch eine externe Magnetfeldstörung verringert, sodass diese während der Flankenerkennung S42 nicht den zweiten Schwellwert 121 übersteigt, kann diese Flanke 140 trotzdem plausibel sein, wenn sie in diesem Zeitfenster detektiert wird. Gleiches gilt, wenn die geschwindigkeitsabhängigen Schwellwerte für den Gradienten und die Zeitdifferenz nicht erreicht werden.

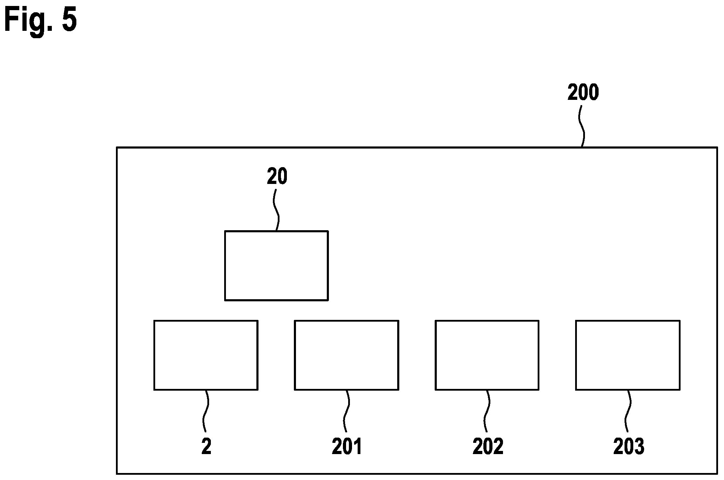

Figur 5 zeigt ein System zur Ermittlung einer Geschwindigkeit gemäß einer Ausführungsform der vorliegenden Erfindung.

Im Detail zeigt Figur 5 ein System 200 zur Ermittlung einer Geschwindigkeit eines einspurigen Fahrzeugs, insbesondere eines Pedelecs oder dergleichen, umfassend

einen stationär am Fahrzeug angeordneten Sensor 2,
eine Ermittlungseinrichtung 20 ausgebildet zum Ermitteln eines zeitliches Verlaufs eines Magnetfelds von einem an einem Rad des Fahrzeugs angeordneten Magneten in zumindest zwei, insbesondere drei, Raumrichtungen basierend auf Messwerten des stationär angeordneten Sensors in zumindest zwei, insbesondere drei, Sensorraumrichtungen wobei die erste der zumindest zwei Raumrichtungen der Fahrtrichtung des Fahrzeugs entspricht und die zweite der zumindest zwei Raumrichtungen der Hochachse des Fahrzeugs entspricht,
eine Flankenerkennungseinrichtung 201, ausgebildet zum Erkennen einer Flanke im zeitlichen Verlauf des Magnetfelds in einer der beiden Raumrichtungen, vorzugsweise in der ersten Raumrichtung mittels

- Ermitteln von Hoch- und Tiefpunkten im zeitlichen Verlauf des Magnetfelds,
- Ermitteln einer fallenden oder steigenden Flanke anhand der zeitlichen Abfolge eines Hoch- und Tiefpunkts,
- Vergleichen der Amplitude der ermittelten Flanke mit einem Schwellwert, wobei die ermittelte Flanke als erkannt gilt, wenn die Amplitude der ermittelten Flanke größer ist als ein erster niedrigerer Schwellwert und/oder größer ist als ein zweiter größerer adaptiver Schwellwert und

eine Geschwindigkeitsermittlungseinrichtung, ausgebildet zum Ermitteln der Geschwindigkeit des Fahrzeugs anhand von zumindest zwei, insbesondere aufeinanderfolgender, erkannter Flanken.

Darüber hinaus ist eine Plausibilisierungseinrichtung 202 angeordnet, die ausgebildet ist, eine Überprüfung der erkannten Flanken hinsichtlich Plausibilität durchzuführen.

Zusammenfassend weist zumindest eine der Ausführungsformen der Erfindung zumindest einen der folgenden Vorteile und/oder zumindest eines der folgenden Merkmale auf:

- Robuste und gleichzeitig zuverlässige Erzeugung eines Zeitsignals zur Ermittlung einer Geschwindigkeit des Fahrzeugs.
- Hohe Flexibilität, da größere Toleranzen bei der Anordnung von Sensor und Magnet ermöglicht werden.
- Reduzierung der Herstellungskoste.
- Reduzierung des Zeitaufwands für die Montage.

Obwohl die vorliegende Erfindung anhand bevorzugter Ausführungsbeispiele beschrieben wurde, ist sie nicht darauf beschränkt, sondern auf vielfältige Weise modifizierbar. Die vorliegende Erfindung ist durch die unabhängigen Ansprüche definiert, und vorteilhafte Ausführungsformen werden in den abhängigen Ansprüchen beschrieben.

**Patentansprüche**

1.  Verfahren zur Ermittlung einer Geschwindigkeit eines einspurigen Fahrzeugs, insbesondere eines Pedelecs oder dergleichen,
    umfassend die Schritte

    - Ermitteln (S1) eines zeitlichen Verlaufs eines Magnetfelds (110) von einem an einem Rad (50) des Fahrzeugs (300) angeordneten Magneten (51) in zumindest zwei, insbesondere drei, Raumrichtungen basierend auf Messwerten eines stationär angeordneten Sensors (2) in zumindest zwei, insbesondere drei, Sensorraumrichtungen (60, 61), wobei die erste der zumindest zwei Raumrichtungen der Fahrtrichtung (70) des Fahrzeugs (300) entspricht und die zweite der zumindest zwei Raumrichtungen der Hochachse (71) des Fahrzeugs entspricht,
    - Erkennen (S42) einer Flanke (140) im zeitlichen Verlauf (110) des Magnetfelds in einer der beiden Raumrichtungen (70, 71), vorzugsweise in der ersten Raumrichtung (70), und
    - Ermitteln der Geschwindigkeit des Fahrzeugs anhand von zumindest zwei, insbesondere aufeinanderfolgender, erkannter Flanken (140).
    - **dadurch gekennzeichnet, dass** das Erkennen der Flanke (140) erfolgt mittels

        - Ermitteln von Hoch- und Tiefpunkten (111, 112) im zeitlichen Verlauf des Magnetfelds (110),
        - Ermitteln einer fallenden oder steigenden Flanke (140) anhand der zeitlichen Abfolge eines Hoch- und Tiefpunkts (111, 112),
        - Vergleichen der Amplitude (130) der ermittelten Flanke (140) mit einem Schwellwert, wobei die ermittelte Flanke (140) als erkannt gilt, wenn die Amplitude (130) der ermittelten Flanke (140) größer ist als ein erster niedrigerer Schwellwert, und/oder größer ist als ein zweiter größerer adaptiver Schwellwert.

2.  Verfahren gemäß Anspruch 1, wobei vor dem Erkennen (S42) der Flanke (140) die Messwerte mittels eines Bandpassfilters gefiltert werden, wobei ein Sperr- und Durchlassbereich des Bandpassfilters an eine vorgegebene Umdrehungsfrequenz des Rades (51) des Fahrzeugs (300) anpasst wird.

3. Verfahren gemäß einem der Ansprüche 1-2, wobei die in mindestens zwei Sensorraumrichtungen (60, 61) ermittelten Messwerte vor dem Erkennen einer Flanke (140) in die Hauptachse (70) des Magnetfelds rotiert werden.

4. Verfahren gemäß Anspruch 3, wobei der Winkel der Hauptachse (70) für die Rotation anhand von Messwerten in der zweiten Raumrichtung (71) (S33) bestimmt wird, insbesondere für eine vorgebbare Anzahl von Flanken.

5. Verfahren nach Anspruch 4, wobei der Winkel der Hauptachse (70) gespeichert wird und für weitere Berechnungen bereitgestellt wird.

6. Verfahren gemäß einem der Ansprüche 1-5, wobei zusätzlich der zeitliche Verlauf des Vektors des Magnetfelds (S41-3) zur Auswertung der steigenden und/oder fallenden Flanken (140) ausgewertet wird, insbesondere zu deren Plausibilisierung.

7. Verfahren gemäß einem der Ansprüche 1-6, wobei eine ermittelte Flanke (140) mittels eines Plausibilisierungsverfahrens (S46) überprüft wird, wobei eine unplausible ermittelte Flanke verworfen wird.

8. Verfahren gemäß Anspruch 7, wobei das Plausibilisierungsverfahren (S46) anhand der ermittelten Flanke (140) eine mögliche Geschwindigkeit berechnet und auf zumindest eine der folgenden Bedingungen überprüft:

   - Wenn die mögliche Geschwindigkeit oberhalb eines vorgebbaren Schwellwerts liegt, wird die ermittelte Flanke (140) verworfen.
   - Wenn der Gradient der ermittelten Flanke (140) unterhalb eines Schwellwerts liegt, wird die ermittelte Flanke (140) verworfen.
   - Wenn die Zeitdifferenz zwischen dem Tiefpunkt (111) der ermittelten Flanke (140) und dem Zeitpunkt des Überschreitens eines Schwellwerts in dem Flankenverlauf oberhalb eines vorgebbaren Schwellwerts ist, wird die ermittelte Flanke (140) verworfen.
   - Wenn die Fahrzeugbeschleunigungen, berechnet aus einer aktuell ermittelten Flanke (140) und einer früheren Flanke (140), oberhalb eines vorgebbaren Schwellwerts liegen, wird die aktuell ermittelte Flanke (140) verworfen.

9. Verfahren nach Anspruch 8, wobei das Plausibilisierungsverfahren (S46) eine Flankenvorhersage (S47), insbesondere anhand von Beschleunigungsdaten des Fahrzeugs, umfasst, sodass eine erkannte Flanke (140) als unplausibel verworfen wird, wenn anhand der Beschleunigungsdaten keine Flanke (140) vorhergesagt wird.

10. Verfahren gemäß Anspruch 9, wobei für den Zeitpunkt der Flankenvorhersage und eines Toleranzbereichs zumindest einer der Schwellwerte vom erstem und zweitem Schwellwert, insbesondere der zweite Schwellwert für die Flankenerkennung und -plausibilisierung verringert werden.

11. Verfahren gemäß einem der Ansprüche 1-10, wobei zur Erkennung der Polarisierung des Magneten (S45) eine vorgebbare Anzahl von ermittelten Flanken (140) und insbesondere ein Winkelverlauf des Magnetfeldvektors (S41-3) ermittelt wird, wobei die Polarisierung anhand eines Vergleichs von maximaler Amplitude der steigenden und der fallenden Amplitude ermittelt wird, wobei wenn die maximale fallende Amplitude größer ist als die maximale steigende Amplitude, die Polarisierung des Magneten umgekehrt angenommen wird und die Messwerte invertiert werden.

12. Verfahren gemäß einem der Ansprüche 1-11, wobei die Polarisierung anhand einer vorgebbaren Anzahl von steigenden und/oder fallenden Flanken (140) ausgewertet wird.

13. System (200) zur Ermittlung einer Geschwindigkeit eines einspurigen Fahrzeugs (300), insbesondere eines Pedelecs oder dergleichen, umfassend

   einen stationär am Fahrzeug angeordneten Sensor (2),
   eine Ermittlungseinrichtung (20) ausgebildet zum Ermitteln (S1) eines zeitliches Verlaufs eines Magnetfelds (110) von einem an einem Rad (50) des Fahrzeugs (300) angeordneten Magneten (51) in zumindest zwei, insbesondere drei, Raumrichtungen basierend auf Messwerten des stationär angeordneten Sensors (2) in zumindest zwei, insbesondere drei, Sensorraumrichtungen (60, 61), wobei die erste der zumindest zwei Raumrichtungen der Fahrtrichtung (70) des Fahrzeugs (300) entspricht und die zweite der zumindest zwei Raumrichtungen der Hochachse (71) des Fahrzeugs entspricht, eine Flankenerkennungseinrichtung (201), ausgebildet zum Erkennen (S42) einer Flanke (140) im zeitlichen Verlauf (110) des Magnetfelds in einer der beiden Raumrichtungen (70, 71), vorzugsweise in der ersten Raumrichtung (70) und eine Geschwindigkeitsermittlungseinrichtung (203) ausgebildet zum Ermitteln der Geschwindigkeit des Fahrzeugs anhand von zumindest zwei, insbesondere aufeinanderfolgender, erkannter Flanken (140), **dadurch gekennzeichnet, dass** das Erkennen (42) der Flanke (140) erfolgt mittels Ermitteln von Hoch- und Tiefpunkten (111, 112) im zeitlichen Verlauf des Magnetfelds (110),

Ermitteln einer fallenden oder steigenden Flanke (140) anhand der zeitlichen Abfolge eines Hoch- und Tiefpunkts (111, 112),
Vergleichen der Amplitude (130) der ermittelten Flanke (140) mit einem Schwellwert, wobei die ermittelte Flanke (140) als erkannt gilt, wenn die Amplitude (130) der ermittelten Flanke (140) größer ist als ein erster niedrigerer Schwellwert und/oder größer ist als ein zweiter größerer adaptiver Schwellwert.

14. Geschwindigkeitsmessvorrichtung für ein einspuriges Fahrzeug, umfassend ein System (200) gemäß Anspruch 13 und eine Radinformationsbereitstellungseinrichtung welche ausgebildet ist, Radinformationen des Rades (50) des Fahrzeugs (300) für das System (200) bereitzustellen.

15. Einspuriges Fahrzeug (300) mit einem System gemäß Anspruch 13 und/oder einer Geschwindigkeitsmessvorrichtung gemäß Anspruch 14.

## Claims

1. Method for determining a speed of a single-track vehicle, in particular a pedelec or the like, comprising the steps:

   - determining (S1) a time evolution of a magnetic field (110) in at least two spatial directions, in particular three spatial directions, from a magnet (51) arranged on a wheel (50) of the vehicle (300), the determination being based on measured values (2) in at least two sensor spatial directions (60, 61), in particular three sensor spatial directions, provided by a sensor arranged at a fixed position, with the first of the at least two spatial directions corresponding to the direction of travel (70) of the vehicle (300) and the second of the at least two spatial directions corresponding to the vertical axis (71) of the vehicle,
   - identifying (S42) a slope (140) in the time evolution (110) of the magnetic field in one of the two spatial directions (70, 71), preferably in the first spatial direction (70), and
   - determining the speed of the vehicle on the basis of at least two, in particular consecutive, identified slopes (140),
   - **characterized in that** the slope (140) is identified by means of
   - determining high and low points (111, 112) in the time evolution of the magnetic field (110),
   - determining a falling or rising slope (140) on the basis of the time sequence of a high point and low point (111, 112),
   - comparing the amplitude (130) of the determined slope (140) with a threshold value, with the determined slope (140) being considered to be identified if the amplitude (130) of the determined slope (140) is greater than a first lower threshold value and/or greater than a second larger adaptive threshold value.

2. Method according to Claim 1, wherein identifying (S42) the slope (140) is preceded by the measured values being filtered by means of a bandpass filter, with a stopband and passband of the bandpass filter being matched to a predetermined rotational frequency of the wheel (51) of the vehicle (300).

3. Method according to any of Claims 1-2, wherein the measured values determined in at least two sensor spatial directions (60, 61) are rotated into the main axis (70) of the magnetic field before a slope (140) is identified.

4. Method according to Claim 3, wherein the angle of the main axis (70) for the rotation is determined on the basis of measured values in the second spatial direction (71) (S33), in particular for a predetermined number of slopes.

5. Method according to Claim 4, wherein the angle of the main axis (70) is stored and provided for further calculations.

6. Method according to any of Claims 1-5, wherein the time evolution of the vector of the magnetic field (S41-3) is additionally evaluated for the evaluation of the rising and/or falling slopes (140), in particular for verifying the plausibility thereof.

7. Method according to any of Claims 1-6, wherein a determined slope (140) is checked by means of a method of verifying plausibility (S46), with a slope determined as being implausible being rejected.

8. Method according to Claim 7, wherein the method of verifying plausibility (S46) on the basis of the determined slope (140) calculates a possible speed and checks for at least one of the following conditions:

   - the determined slope (140) is rejected if the possible speed is above a predeterminable threshold value,
   - the determined slope (140) is rejected if the gradient of the determined slope (140) is below a threshold value,
   - the determined slope (140) is rejected if the time difference between the low point (111) of the determined slope (140) and the time when a threshold value in the evolution of the slope is exceeded is above a predeterminable threshold value,

- a currently determined slope (140) is rejected if the vehicle accelerations, calculated from the currently determined slope (140) and an earlier slope (140), are above a predeterminable threshold value.

9. Method according to Claim 8, wherein the method of verifying plausibility (S46) comprises an slope prediction (S47), in particular based on acceleration data about the vehicle, such that an identified slope (140) is rejected as implausible if no slope (140) is predicted on the basis of the acceleration data.

10. Method according to Claim 9, wherein for the time of the slope prediction and a tolerance range, at least one of the threshold values of the first and second threshold values is reduced, in particular the second threshold value for the slope identification and verification of the plausibility thereof.

11. Method according to any of Claims 1-10, wherein a predeterminable number of determined slopes (140) and in particular an angle evolution of the magnetic field vector (S41-3) are determined for the purpose of identifying the polarization of the magnet (S45), with the polarization being determined on the basis of a comparison of maximum amplitude of the rising and falling amplitudes, the polarization of the magnet being assumed to be reversed and the measured values being inverted if the maximum falling amplitude is greater than the maximum rising amplitude.

12. Method according to any of Claims 1-11, wherein the polarization is evaluated on the basis of a predeterminable number of rising and/or falling slopes (140).

13. System (200) for determining a speed of a single-track vehicle (300), in particular a pedelec or the like, comprising

a sensor (2) arranged on the vehicle at a fixed position,
a determination device (20) designed for determining (S1) a time evolution of a magnetic field (110) in at least two spatial directions, in particular three spatial directions, from a magnet (51) arranged on a wheel (50) of the vehicle (300), the determination being based on measured values (2) in at least two sensor spatial directions (60, 61), in particular three sensor spatial directions, provided by the sensor arranged at a fixed position, with the first of the at least two spatial directions corresponding to the direction of travel (70) of the vehicle (300) and the second of the at least two spatial directions corresponding to the vertical axis (71) of the vehicle,
a slope identification device (201) designed for identifying (S42) a slope (140) in the time evolution (110) of the magnetic field in one of the two spatial directions (70, 71), preferably in the first spatial direction (70), and
a speed determination device (203) designed for determining the speed of the vehicle on the basis of at least two, in particular consecutive, identified slopes (140), **characterized in that** the slope (140) is identified (42) by means of determining high and low points (111, 112) in the time evolution of the magnetic field (110), determining a falling or rising slope (140) on the basis of the time sequence of a high point and low point (111, 112), comparing the amplitude (130) of the determined slope (140) with a threshold value, with the determined slope (140) being considered to be identified if the amplitude (130) of the determined slope (140) is greater than a first lower threshold value and/or greater than a second larger adaptive threshold value.

14. Speed measuring apparatus for a single-track vehicle, comprising a system (200) according to Claim 13 and a wheel information provision device designed for providing wheel information relating to the wheel (50) of the vehicle (300) for the system (200).

15. Single-track vehicle (300) having a system according to Claim 13 and/or a speed measuring apparatus according to Claim 14.

**Revendications**

1. Procédé pour déterminer une vitesse d'un véhicule à voie unique, en particulier d'un vélo à assistance électrique ou similaire,
comprenant les étapes

- détermination (S1) d'un profil temporel d'un champ magnétique (110) d'un aimant (51) disposé sur une roue (50) du véhicule (300) dans au moins deux, en particulier trois directions spatiales, sur la base de valeurs de mesure d'un capteur (2) disposé de manière stationnaire dans au moins deux, en particulier trois directions spatiales (60, 61) de capteur, la première des au moins deux directions spatiales correspondant à la direction de déplacement (70) du véhicule (300) et la deuxième des au moins deux directions spatiales correspondant à l'axe vertical (71) du véhicule,
- détection (S42) d'un flanc (140) dans le profil temporel (110) du champ magnétique dans une des deux directions spatiales (70, 71), de préférence dans la première direction spatiale (70), et
- détermination de la vitesse du véhicule à l'aide d'au moins deux flancs (140) identifiés, se suivant l'un l'autre,
- **caractérisé en ce que** l'identification du flanc (140) est effectuée au moyen de
- la détermination des points haut et bas (111, 112) du profil temporel du champ magnétique (110),
- la détermination d'un flanc (140) descendant ou montant à l'aide de la séquence temporelle d'un point haut et d'un point bas (111, 112),
- la comparaison de l'amplitude (130) du flanc (140) déterminé avec une valeur de seuil, le flanc (140) déterminé étant considéré comme identifié lorsque l'amplitude (130) du flanc (140) déterminé est supérieure à une première valeur de seuil inférieure et/ou est supérieure à une deuxième valeur de seuil adaptative supérieure.

2. Procédé selon la revendication 1, les valeurs de mesure étant filtrées au moyen d'un filtre passe-bande avant l'identification (S42) du flanc (140), une zone de blocage et de passage du filtre passe-bande étant adaptée à une fréquence de rotation prédéfinie de la roue (51) du véhicule (300).

3. Procédé selon l'une des revendications 1 à 2, les valeurs de mesure déterminées dans au moins deux directions spatiales (60, 61) de capteur étant tournées dans l'axe principal (70) du champ magnétique avant qu'un flanc (140) ne soit identifié.

4. Procédé selon la revendication 3, l'angle de rotation de l'axe principal (70) étant défini à l'aide de valeurs de mesure dans la deuxième direction spatiale (71) (S33), en particulier pour un nombre de flancs pouvant être prédéfini.

5. Procédé selon la revendication 4, l'angle de l'axe principal (70) étant mémorisé et fourni pour d'autres calculs.

6. Procédé selon l'une des revendications 1 à 5, l'évolution dans le temps du vecteur du champ magnétique (S41-3) étant évaluée en supplément pour l'évaluation des flancs (140) montants et/ou descendants, en particulier pour le contrôle de leur plausibilité.

7. Procédé selon l'une des revendications 1 à 6, un flanc (140) déterminé étant vérifié au moyen d'un procédé de contrôle de plausibilité (S46), un flanc déterminé non plausible étant rejeté.

8. Procédé selon la revendication 7, le procédé de contrôle de plausibilité (S46) calculant une vitesse possible à l'aide du flanc (140) déterminé et en vérifiant au moins une des conditions suivantes :

- si la vitesse possible est supérieure à une valeur de seuil pouvant être prédéfinie, le flanc (140) déterminé est rejeté.
- si le gradient du flanc (140) déterminé est inférieur à une valeur de seuil, le flanc (140) déterminé est rejeté.
- si la différence de temps entre le point bas (111) du flanc (140) déterminé et le moment du dépassement d'une valeur de seuil dans le profil de flanc est au-dessus d'une valeur de seuil pouvant être prédéfinie, le flanc (140) déterminé est rejeté.
- si les accélérations de véhicule, calculées à partir d'un flanc (140) déterminé et d'un flanc antérieur (140), sont supérieures à une valeur de seuil pouvant être prédéfinie, le flanc (140) déterminé est rejeté.

9. Procédé selon la revendication 8, le procédé de contrôle de plausibilité (S46) comprenant une prédiction de flanc (S47), en particulier à l'aide de données d'accélération du véhicule, si bien qu'un flanc (140) identifié est rejeté comme non plausible si aucun flanc (140) n'est prédit à l'aide des données d'accélération.

10. Procédé selon la revendication 9, au moins une des valeurs de seuil des première et deuxième valeurs de seuil, en particulier la deuxième valeur de seuil pour l'identification de flanc et le contrôle de plausibilité, étant réduite pendant la durée de la prédiction de flanc et d'une plage de tolérance.

11. Procédé selon l'une des revendications 1 à 10, un nombre pouvant être prédéfini de flancs (140) déterminés et en particulier un profil angulaire du vecteur de champ magnétique (S41-3) étant déterminés pour identifier la polarisation de l'aimant (S45), la polarisation étant déterminée à l'aide d'une comparaison de l'amplitude maximale de l'amplitude montante et de l'amplitude descendante, la polarisation de l'aimant étant supposée à l'inverse et les valeurs de mesure étant inversées lorsque l'amplitude descendante maximale est supérieure à l'amplitude montante maximale.

12. Procédé selon l'une des revendications 1 à 11, la polarisation étant évaluée à l'aide d'un nombre pouvant être prédéfini de flancs (140) montants et/ou descendants.

13. Système (200) permettant de déterminer une vitesse d'un véhicule (300) à voie unique, en particulier d'un vélo à assistance électrique ou similaire, comprenant

un capteur (2) disposé de manière stationnaire sur le véhicule,

un équipement de détermination (20) formé pour déterminer (S1) un profil temporel d'un champ magnétique (110) d'un aimant (51) disposé sur une roue (50) du véhicule (300) dans au moins deux, en particulier trois directions spatiales, sur la base de valeurs de mesure du capteur (2) disposé de manière stationnaire dans au moins deux, en particulier trois directions spatiales (60, 61) de capteur, la première des au moins deux directions spatiales correspondant à la direction de déplacement (70) du véhicule (300) et la deuxième des au moins deux directions spatiales correspondant à l'axe vertical (71) du véhicule,

un équipement d'identification (201) de flanc formé pour identifier (S42) un flanc (140) dans le profil temporel (110) du champ magnétique dans une des deux directions spatiales (70, 71), de préférence dans la première direction spatiale (70), et

un système de détermination de vitesse (203) formé pour déterminer la vitesse du véhicule à l'aide d'au moins deux flancs (140) identifiés, en particulier se suivant l'un l'autre, **caractérisé en ce que** l'identification (42) du flanc (140) est effectuée au moyen

de la détermination de points hauts et bas (111, 112) dans le profil temporel du champ magnétique (110),

de la détermination d'un flanc (140) descendant ou montant à l'aide de la séquence temporelle d'un point haut et d'un point bas (111, 112),

de la comparaison de l'amplitude (130) du flanc (140) déterminé à une valeur de seuil, le flanc (140) déterminé étant considéré comme identifié lorsque l'amplitude (130) du flanc (140) déterminé est supérieure à une première valeur de seuil inférieure et/ou est supérieure à une deuxième valeur de seuil adaptative supérieure.

14. Dispositif de mesure de vitesse pour un véhicule à voie unique, comprenant un système (200) selon la revendication 13 et un équipement de fourniture d'informations de roue qui est formé pour fournir des informations de roue de la roue (50) du véhicule (300) pour le système (200).

15. Véhicule (300) à voie unique avec un système selon la revendication 13 et/ou un dispositif de mesure de vitesse selon la revendication 14.

EP 4 388 323 B1

**Fig. 1**

# Fig. 2

EP 4 388 323 B1

## Fig. 3

EP 4 388 323 B1

# Fig. 4

EP 4 388 323 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3435094 A2
- US 2019353677 A1
- US 2008315865 A1
- DE 112012001676 T5
- DE 19939979 A1